# EUROPÄISCHE PATENTSCHRIFT

(11) **EP 0 392 182 B1**
(45) Veröffentlichungstag und Bekanntmachung des Hinweises auf die Patenterteilung: **15.11.1995**
(21) Anmeldenummer: 90103958.6
(22) Anmeldetag: 01.03.1990
(51) Int. Cl.: H03K 5/19, G01P 3/48

(54) **Verfahren und Schaltung zur Auswertung von kontinuierlich auftretenden Zeitmarken**
Method and circuit for monitoring a continuous flow of time markings
Procédé et circuit pour l'évaluation d'un débit continu de marques temporelles

(30) Priorität: 11.04.1989 DE 3911830
(43) Veröffentlichungstag der Anmeldung: 17.10.1990
(73) Patentinhaber: ROBERT BOSCH GMBH, 70442 Stuttgart (DE)
(72) Erfinder: Gärtner, Siegfried, Dipl.-Ing., D-1000 Berlin 65 (DE); Pham, Minh-Chanh, D-1000 Berlin 21 (DE); Widmann, Friedrich, Dipl.-Ing., D-1000 Berlin 21 (DE)

(56) Entgegenhaltungen:
- EP-A- 0 020 071
- WO-A-85/05511
- DE-A- 3 511 444
- SU-A- 1 064 447
- SU-A- 1 338 034
- US-A- 3 930 201

## Beschreibung

Die Erfindung betrifft ein Verfahren sowie eine Schaltung zur berührungslosen Geschwindingkeitsmessung von Fahrzeugen nach dem Oberbegriff der Ansprüche 1 und 7. Hierbei müssen kontinuierlich auftretende Zeitmarken ausgewertet werden.

Aus der Zeitschrift "Bosch Technische Berichte", Band 8, 1986, Heft 1/2, Seiten 57 - 65 ist ein autarkes Ortungssystem für Einsatzfahrzeuge bekannt, das zur Erfassung der Geschwindigkeit ein Verfahren anwendet, das mittels eines optischen Gitters die Relativbewegung zu einer statisch rauhen Oberfläche, nämlich der Straßenoberfläche, ermittelt. Dabei treten proportional zur Geschwindigkeit Ortswellen auf, die nach einer Filterung als geschwindigkeitsabhängige Zeitmarken verarbeitet werden können. Der Vorteil dieses Verfahrens besteht darin, daß unabhängig vom Reifenverschleiß und Luftdruck die Geschwindigkeit mit gleichbleibender Genauigkeit und sehr hoher Präzision erfaßt werden kann.

Nachteilig ist es jedoch, daß bei optisch ungünstiger Ausbildung der Oberflächen oder einer Änderung des Straßenbelages die Amplitude der Ortswellen abnehmen kann, so daß sich aus den Zeitmarken keine Pulse für die Messung der Abstände gewinnen lassen oder daß einzelne Pulse in einer Folge von Pulsen ausfallen.

Bei der Auswertung der Pulse würde dies zu einer sprunghaften Änderung der aus den Abständen der Pulse gewonnenen Größe, z.B. der Geschwindigkeit führen. Eine in anderer Richtung wirkende Änderung kann eintreten, wenn zusätzlich zu der kontinuierlichen Folge der Zeitmarken und der daraus gewonnenen Pulse durch Störeinflüsse ein oder mehrere Pulse als zusätzliche Störpulse erscheinen.

Die beschriebene Problematik ist nicht auf das hier angesprochene Verfahren zur Ermittlung einer Geschwindigkeit beschränkt. Die Möglichkeit, daß bei kontinuierlich auftretenden Zeitmarken, aus denen Pulse gewonnen werden, Pulse verloren gehen oder Pulse an falscher Stelle eingefügt werden, kann auch bei anderen Anwendungsfällen auftreten.

Aus der SU-A-1 064 447 ist ein Verfahren zur Synchronisation von Übertragungssystemen bekannt. Dabei wird die Übertragung eines Signals mit Hilfe von Zählimpulsen überwacht. Erscheint zu einem vorgegebenen Zeitpunkt kein Signal, dann wird ein Ersatzsignal gebildet. Ein weiteres Signal-Übertragungssystem ist aus der SU-A-1 338 034 bekannt. Bei diesem System wird bei einer Frequenz die Wiederholung der Periode eines Pulses überwacht. Fehlt ein Signal, dann wird ebenfalls ein entsprechender Ersatzimpuls gebildet. Dieses Übertragungssystem wird zur Steuerung, Verarbeitung und Übertragung von Informationen verwendet. Anwendungen in Verbindung mit einer Geschwindigkeitsmessung eines Fahrzeuges sind nicht vorgesehen.

Der Erfindung liegt die Aufgabe zugrunde, ein Verfahren bzw. eine Schaltung der im Oberbegriff der Ansprüche 1 bzw. 7 angegebenen Art, dahingehend zu verbessern, daß die Auswirkungen fehlerhaft auftretender oder nicht auftretender Pulse auf ein Meßergebnis verringert oder beseitigt werden.

Diese Aufgabe wird durch die im kennzeichnenden Teil der Ansprüche 1 bzw. 7 angegebenen Merkmale gelöst.

Die Erfindung geht von der Überlegung aus, daß bei einer Folge von kontinuierlich auftretenden Zeitmarken unter normalen Umständen abrupte Änderungen der zeitlichen Folge ausgeschlossen sind.

Dementsprechend kann und muß ein auf einen erkannten Puls nachfolgender Puls nur in einem begrenzten Zeitabschnitt auftreten. Die Erfindung nutzt dies, indem in dem Zeitabschnitt ein Zeitfenster gebildet wird, in dem das Eintreffen eines weiteren Pulses überwacht wird. Dadurch werden außerhalb des Zeitabschnittes auftretende und nach den vorgenannten Überlegungen als Störungen betrachtete Pulse ausgeblendet.

Um den weiteren Fehler zu beseitigen, daß ein im Zeitfenster erwarteter Puls völlig ausfällt, wird der nicht eintreffen Puls durch einen Ersatzpuls - nachfolgend auch als künstlich erzeugter Puls bezeichnet - im Zeitfenster ersetzt. Dieser Puls bildet dann einen Bezugswert für das weitere Zeitfenster, in dem das Eintreffen eines übernächsten Pulses überwacht wird. Wenn darin ein weiterer Puls erkannt wird, kann die Auswertung der Abstände der Pulse praktisch ohne Störungen fortgesetzt werden. Auch die Überbrückung mehrerer ausgefallener Pulse ist möglich unter der Voraussetzung, daß sich während der Ausfallperiode die Abstände nicht plötzlich ändern, so daß anschließend aus den Zeitmarken gewonnene Pulse nicht mehr in das Zeitfenster fallen.

Weiterbildungen der Erfindung sehen vor, daß die Untergrenze und die Obergrenze des Zeitfensters in Abhängigkeit der zeitlichen Folge der Pulse verschoben werden können.

Im Hinblick auf die Möglichkeit, die Erfindung bei der berührungslosen Geschwindigkeitsmessung von Fahrzeugen einzusetzen, berücksichtigt diese Weiterbildung, daß sich die maximale Beschleunigung oder Verzögerung des Fahrzeugs in Abhängigkeit der jeweiligen Geschwindigkeit ändert.

Weiterbildungen und vorteilhafte Ausgestaltungen der Erfindung ergeben sich aus den Ansprüchen, der Beschreibung und der Zeichnung, anhand der die Erfindung näher erläutert ist.

In der Zeichnung zeigen:
- Fig. 1: Pulsfolgen mit Störpulsen oder ausgefallenen Pulsen am Eingang und Ausgang einer Schaltung nach der Erfindung,
- Fig. 2: eine Funktion zur Darstellung der Abhängigkeit von Untergrenzen und Obergrenzen des Zeitfensters in Bezug auf den Kehrwert der zeitlichen Abstände der Pulse,
- Fig. 3: eine Darstellung der Zeitpunkte einer Pulsfolge mit Ober- und Untergrenzen eines Zeitfensters, und
- Fig. 4: eine Schaltung nach der Erfindung.

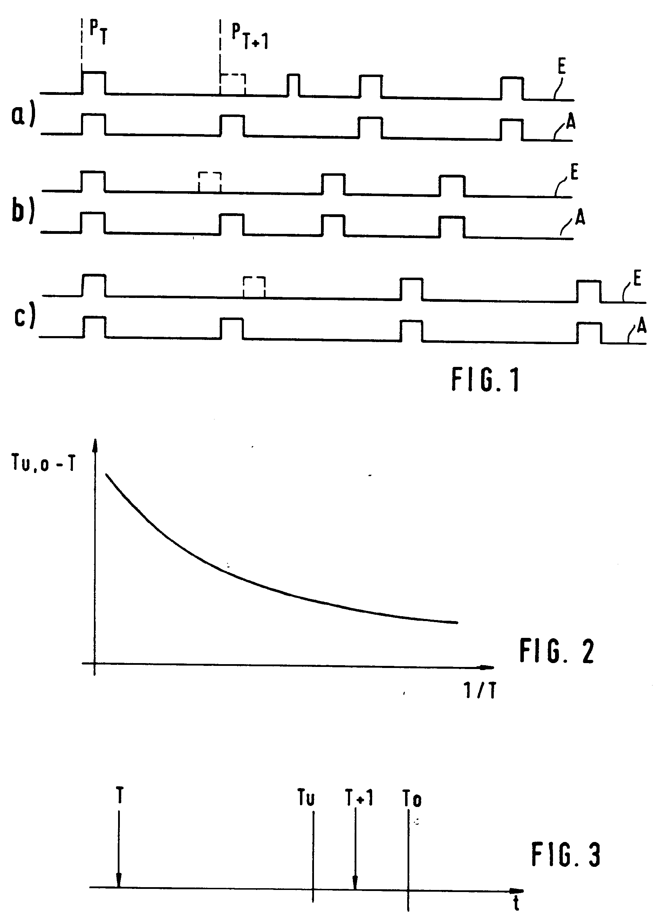

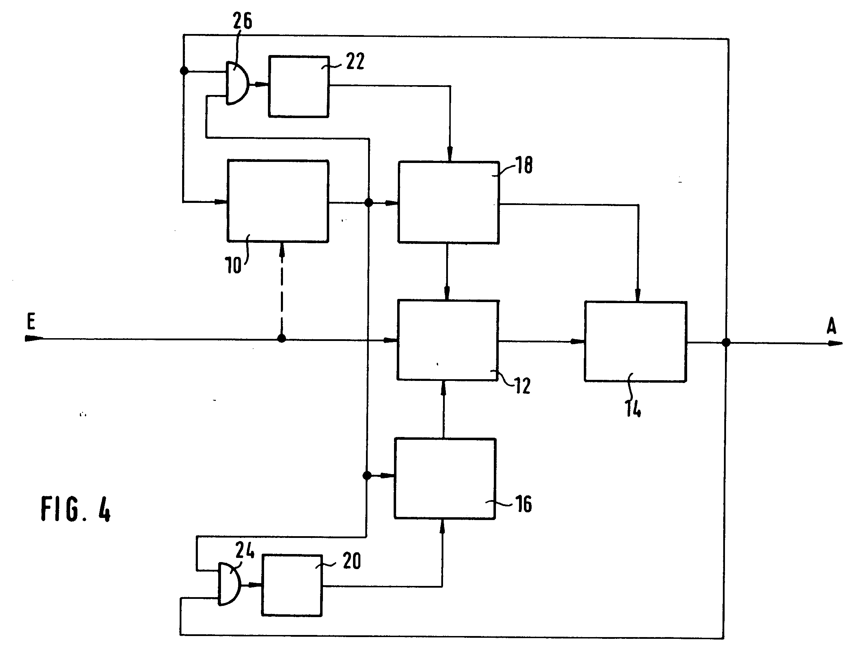

In Fig. 1 a - c sind verschiedene Pulsfolgen, jeweils am Eingang E und Ausgang A einer noch zu erläuternden und in Fig. 4 dargestellten Schaltung gezeigt.

Es handelt sich bei allen drei Pulsfolgen a, b und c um kontinuierliche Folgen, wobei jedoch in a eine konstante Pulsfolge entsprechend einer konstanten Geschwindigkeit bei einem Fahrzeug, in b eine sich in den zeitlichen Abständen verkürzende Pulsfolge entsprechend einer Beschleunigung des Fahrzeugs sowie in c eine sich in den Abständen vergrößernde Pulsfolge entsprechend einer Verzögerung des Fahrzeugs dargestellt ist. In den Beispielen a, b und c ist jeweils der zweite Puls ausgefallen, zur Verdeutlichung seiner örtlichen Anordnung aber gestrichelt dargestellt. In a ist zusätzlich zwischen dem ausgefallenen zweiten Puls und dem dritten Puls noch ein Störpuls dargestellt.

Die Pulsfolgen in den Teilbildern a, b und c, welche mit dem großen Buchstaben E bezeichnet sind, werden dem Eingang der in Fig. 4 dargestellten Schaltung zugeführt. Die Wirkungsweise der Schaltung ergibt sich aus den jeweils darunter gezeichneten Pulsfolgen, die mit dem großen Buchstaben A bezeichnet sind. Solange Pulse in der Umgebung eines erwarteten Pulses eintreffen, werden diese Pulse am Ausgang A wiedergegeben. Die Umgebung des erwarteten Pulses ist dabei durch ein Zeitfenster begrenzt. Fällt in das Zeitfenster kein Puls, so wird dennoch ein künstlicher Puls erzeugt, der den nicht eintreffenden Puls im Zeitfenster ersetzt.

Somit ergibt sich bei den Darstellungen in Fig. 1 auch dann ein Puls bei der mit A bezeichneten Pulsfolge, wenn der entsprechende Puls bei der mit E bezeichneten Pulsfolge ausfällt (durch die gestrichelt gezeichneten Pulse dargestellt). Pulse, die außerhalb des Zeitfensters liegen, werden unterdrückt. Dieser Fall ist bei a dargestellt, wo zwischen dem zweiten, ausgefallenen Puls und dem dritten Puls ein zusätzlicher Störpuls eingefügt ist.

In Fig. 1 ist davon ausgegangen, daß bis zu dem ersten Puls im Zeitpunkt T der mit P_{T} bezeichnet ist, konstante Pulsfolgen auftraten. Erst danach findet eine Änderung der zeitlichen Abstände bei b und c statt. Wird der künstlich erzeugte Puls nun im Abstand der letzten vorangehenden Pulse oder, falls die zeitliche Folge vorangehender Pulse ausgewertet und extrapoliert wird, der künstlich erzeugte Puls im Abstand des extrapolierten Wertes eingesetzt, so ergibt sich in allen drei Fällen ein gleicher Abstand T+1, so daß der künstlich erzeugte Puls als P_{T+1} zeitlich angeordnet wird. Bis auf den Fall a fällt er nicht mit dem Zeitpunkten zusammen, bei denen die Pulse am Eingang E bei Vorhandensein auftreten müßten. Wenn die Grenzen des Zeitfensters entsprechend bemessen sind und nicht eine zu große Folge von Pulsen ausfällt, kann das kurzzeitig geringfügige verfälschte Meßergebnis wieder korrigiert werden.

In Fig. 2 ist die Abhängigkeit zwischen den Unter- und Obergrenzen des Zeitfensters zum Kehrwert der zeitlichen Abstände zwischen den Pulsen dargestellt. Der Verlauf der Kurve ist abhängig davon, von welchem Objekt die Zeitmarken erzeugt werden. Handelt es sich z.B. um ein Fahrzeug, bei dem die Zeitmarken im Zusammenhang mit der Ermittlung einer Relativgeschwindigkeit zur Fahrbahnoberfläche erzeugt werden, so ist die Kurve von der maximalen Beschleunigung, also vom Straßenzustand sowie der Motorleistung abhängig und von der maximalen Verzögerung und damit ebenfalls vom Straßenzustand.

Die Werte für die Untergrenze und Obergrenze können auch unterschiedlichen Funktionen folgen. Es ist zweckmäßig, zur Bestimmung der Untergrenze und Obergrenze des Zeitfensters die ermittelten Werte in einer Tabelle zu speichern und bei gegebenen zeitlichen Abständen der Pulse sie der Tabelle zu entnehmen und bei Festlegung des Zeitfensters einzusetzen.

In Fig. 3 sind Zeitpunkte für das Eintreffen von Pulsen sowie für die Ober- und Untergrenze eines Zeitfensters eingetragen. Ausgehend von einem Zeitpunkt T, in dem ein Puls entweder ermittelt oder künstlich erzeugt wird, wird im erwarteten Abstand ein Zeitfenster gebildet. Dieses ist durch Zeitpunkte T_{U} als Untergrenze und T_{O} als Obergrenze begrenzt. Innerhalb dieses Zeitfensters kann ein weiterer Puls im Zeitpunkt T+1 auftreten und erfaßt werden oder bei nicht Eintreffen durch einen künstlich erzeugten Puls ersetzt werden.

Im Falle eines künstlich erzeugten Pulses besteht noch das Problem, wohin dieser innerhalb des Zeitfensters versetzt werden soll. Im einfachsten Fall könnte dies dadurch gelöst werden, daß der Abstand der letzten vorangehenden Pulse bestimmt wird und der künstlich erzeugte Puls in dem selben Abstand nach dem letzten Puls eingesetzt wird. Bei gleichbleibender Pulsfolge wäre diese Maßnahme korrekt, bei sich ändernder Pulsfolge würde dagegen ein Fehler auftreten.

Eine andere Möglichkeit besteht darin, die zeitliche Folge vorhergehender Pulse auszuwerten und zu extrapolieren. Dann könnte der künstlich erzeugte Puls im Abstand des extrapolierten Wertes nach dem letzten Puls eingesetzt werden. Durch diese Maßnahme besteht die Möglichkeit, neben konstanten Pulsfolgen auch stetig verkleinernde oder vergrößernde Pulsfolgen zu berücksichtigen. Nicht erfaßt werden jedoch Fälle, in denen eine Unstetigkeit vorliegt.

Da in der Praxis im zeitlichen Ablauf erst die Obergrenze T_{O} des Zeitfensters abgewartet werden muß, ehe über die Einfügung eines künstlichen Pulses entschieden werden kann, besteht im zeitlichen Ablauf nicht mehr die Möglichkeit, diesen Puls noch zeitrichtig einzufügen. Eine Abhilfe läßt sich dadurch schaffen, daß im Zeitpunkt der Obergrenze des Zeitfensters die Meßeinrichtung zum Erfassen der zeitlichen Abstände aufeinanderfolgender Pulse um die bis zum Zeitpunkt der Obergrenze verstrichene Zeit voreingestellt wird. Das Zeitfenster für den nachfolgenden zu erwartenden Puls liegt dann wieder richtig.

Fig. 4 zeigt schließlich eine Schaltung zur Auswertung von kontinuierlich auftretenden Zeitmarken nach der Erfindung. Dabei werden Pulse, die aus Zeitmarken gewonnen werden und in deren zeitlicher Folge auch Pulse ausfallen oder Störpulse zusätzlich auftreten können, über einen Eingang E eingespeist und eine kontinuierlich auftretende Folge von Pulsen ist am Ausgang A abgreifbar. Die Schaltung umfaßt eine Zeitmeßeinrichtung 10, eine zeitfenstergesteuerte Torschaltung 12, einen Pulsgenerator 14, Vergleichsschaltungen 16 und 18 sowie logische Verknüpfungsglieder 24 und 26.

Der Eingang E ist über eine gestrichelte Verbindung mit der Zeitmeßeinrichtung 10 verbunden. Damit ist angedeutet, daß bei Beginn einer Messung zunächst ein "echter" Puls auftreten muß, damit das weitere Verfahren in Gang gesetzt werden kann. Anschließend werden jedoch nur Pulse ausgewertet, die am Ausgang A erzeugt werden, damit die Zeitmeßeinrichtung 10 nicht gestört wird.

Der Eingang E ist mit der Torschaltung 12 verbunden, die zeitfenstergesteuert ist. Innerhalb des Zeitfensters wird überwacht, Ob Pulse am Eingang E auftreten. Diese Pulse werden dann unmittelbar an den Ausgang A weitergegeben. Treten innerhalb des Zeitfensters keine Pulse auf, so wird ein nachfolgender Pulsgenerator 14 veranlaßt, einen künstlichen Puls zu erzeugen.

Die Steuerung der Torschaltung 12, also das Öffnen und Schließen erfolgt durch Vergleichsschaltungen 16 und 18. Dabei dient die Vergleichsschaltung 16 zur Öffnung der Torschaltung und vergleicht eine festgelegte Untergrenze des Zeitfensters mit der aktuellen Zeit, während die Vergleichsschaltung 18 die Torschaltung 12 schließt, sobald eine festgelegte Obergrenze für das Zeitfenster mit der aktuellen Zeit übereinstimmt.

Von der Vergleichsschaltung 18 für die Obergrenze des Zeitfensters wird außerdem der Pulsgenerator 14 gesteuert, da der von diesem erzeugte Puls erst dann eingesetzt werden kann, wenn das Zeitfenster abgewartet wurde und die Obergrenze erreicht ist.

Die Vergleichsschaltungen 16 und 18 erhalten einmal von der Zeitmeßeinrichtung 10 die aktuelle Zeit und zum anderen die Werte für die Unter- und Obergrenzen des Zeitfensters.

Dazu sind ihre Eingänge mit Ausgängen von Speichern 20 und 22 verbunden, in denen die Werte von Unter und Obergrenzen tabellarisch gespeichert sind. Die Speicher 20 und 22 sind durch die Zeitmeßeinrichtung 10 adressierbar. Zusätzlich wird bei der Adressierung auch der Abstand der am Ausgang A auftretenden Pulse berücksichtigt. Dementsprechend wird den Speichern 20 und 22 die aktuelle Zeit sowie die Angabe der am Ausgang A auftretenden Pulse durch logische Verknüpfungsglieder 24 und 26 zugeführt.

Falls aus den zeitlichen Abständen der Pulse und damit der Zeitmarken Werte für eine Geschwindigkeit ermittelt werden sollen, kann dies auch durch die Zeitmeßeinrichtung 10 durchgeführt werden. Ansonsten lassen sich die am Ausgang A abgreifbaren Pulse einer weiteren Einrichtung zuführen, in der die entsprechenden Pulse verarbeitet werden können.

Die Schaltung gemäß Fig. 4 ist eine mögliche Ausgestaltung zur Durchführung der Auswertung von kontinuierlich auftretenden Zeitmarken. Es besteht auch die Möglichkeit, die in der Schaltung durch diskrete Schaltungselemente ausgeführten Funktionen mit Hilfe eines Rechners durchzuführen, indem die Funktionen programmge steuert simuliert und durchlaufen werden.

## Patentansprüche

1. Verfahren zur berührungslosen Geschwindigkeitsmessung von Fahrzeugen, wobei mittels einer Optik Licht auf die Oberfläche eines Straßenbelages gesendet und die Reflexionen gegenüber einem optischen Gitter als kontinuierlich auftretende Zeitmarken ausgewertet werden, aus denen Pulse gewonnen und deren zeitliche Abstände gemessen werden, dadurch gekennzeichnet, daß im Abstand aufeinander folgender Pulse nach dem jeweils letzten Puls ein Zeitfenster gebildet wird, innerhalb dem das Eintreffen eines weiteren Pulses überwacht wird und daß bei Nichteintreffen des Pulses dieser durch einen Ersatzpuls im Zeitfenster ersetzt wird, wobei in Abhängigkeit von der Geschwindigkeit des Fahrzeuges die Untergrenze und die Obergrenze des Zeitfensters verschoben wird.

2. Verfahren nach Anspruch 1, dadurch gekennzeichnet, daß Werte für eine maximale zeitliche Verschiebung der Zeitmarken und der daraus gewonnenen Pulse bestimmt oder berechnet werden und daß die Untergrenze des Zeitfensters um den Wert der maximalen zeitlichen Voreilung vor und die Obergrenze um den Wert der maximalen zeitlichen Nacheilung hinter dem erwarteten Zeitpunkt eines weiteren Pulses gelegt wird.

3. Verfahren nach Anspruch 1 oder 2, dadurch gekennzeichnet, daß der Zusammenhang zwischen den zeitlichen Abständen der Pulse und der Untergrenze bzw. der Obergrenze des Zeitfensters ermittelt oder berechnet und in einer Tabelle gespeichert wird und daß die gespeicherten Werte der Untergrenze und der Obergrenze bei gegebenen zeitlichen Abständen der Pulse der Tabelle entnommen und bei der Festlegung des Zeitfensters eingesetzt werden.

4. Verfahren nach einem der Ansprüche 1 bis 3, dadurch gekennzeichnet, daß bei Nichteintreffen des Pulses der Ersatzpuls im Abstand der letzten vorangehenden Pulse nach dem letzten Puls im Zeitfenster eingesetzt wird.

5. Verfahren nach einem der Ansprüche 1 bis 3, dadurch gekennzeichnet, daß bei Nichteintreffen des Pulses die zeitliche Folge vorangehender Pulse ausgewertet und extrapoliert wird und daß der Ersatzpuls im Abstand des extrapolierten Wertes nach dem letzten Puls im Zeitfenster eingesetzt wird.

6. Verfahren nach Anspruch 4 oder 5, dadurch gekennzeichnet, daß der Ersatzpuls im Zeitfenster der Obergrenze des Zeitfensters eingesetzt wird, indem eine die zeitlichen Abstände aufeinanderfolgender Pulse erfassende Meßeinrichtung um die bis zum Zeitpunkt der Obergrenze verstrichene Zeit voreingestellt wird.

7. Schaltung zur berührungslosen Geschwindigkeitsmessung von Fahrzeugen, wobei mittels einer Optik Licht auf die Oberfläche eines Straßenbelages gesendet und die Reflexionen gegenüber einem optischen Gitter als kontinuierlich auftretende Zeitmarken auswertbar sind, aus denen Pulse gewonnen und deren zeitliche Abstände gemessen werden, wobei zur Messung der zeitlichen Abstände der Pulse eine vorzugsweise als Zähler ausgebildete Zeitmeßeinrichtung (10) vorgesehen ist, dadurch gekennzeichnet, daß die Pulse einer zeitfenstergesteuerten Torschaltung (12) zugeführt sind, daß die Torschaltung (12) mit einem Pulsgenerator (14) verbunden ist, welcher bei Nichteintreffen eines Pulses einen Ersatzpuls erzeugt, daß Vergleichsschaltungen (16, 18) vorgesehen sind, welche festgelegte Untergrenzen bzw. Obergrenzen für das Zeitfenster mit der aktuellen Zeit vergleichen, wobei die Eingänge für Unter- und Obergrenzen der Vergleichsschaltungen (16, 18) mit Ausgängen von Speichern (20, 22) verbunden sind, in denen Werte von Unter- und Obergrenzen tabellarisch gespeichert sind und daß die Speicher (20, 22) durch die Zeitmeßeinrichtung (10) adressierbar sind.

8. Schaltung nach Anspruch 7, dadurch gekennzeichnet, daß die Torschaltung (12) durch die Vergleichsschaltungen (16, 18) öffen- und schließbar ist.

9. Schaltung nach Anspruch 7 oder 8, dadurch gekennzeichnet, daß der Pulsgenerator (14) mit einem Setzeingang der Zeitmeßeinrichtung (10) verbunden ist, und daß der Ersatzpuls im Zeitpunkt der Obergrenze des Zeitfensters eingesetzt wird, indem die Meßeinrichtung (10) um die bis zum Zeitpunkt der Obergrenze verstrichene Zeit voreingestellt wird.

## Claims

1. Method for the contactless speed measurement of vehicles, light being transmitted onto the surface of a road surface by means of optics, and the reflections being evaluated with respect to an optical grid as continuously occurring time markings, from which pulses are obtained and their time spacings are measured, characterized in that, at the spacing of successive pulses, after the last pulse in each case, a time window is formed within which the arrival of a further pulse is monitored, and in that in the event of the non-arrival of the pulse, this is substituted by a substitute pulse in the time window, the lower limit and the upper limit of the time window being shifted as a function of the speed of the vehicle.

2. Method according to Claim 1, characterized in that values for a maximum time shift of the time markings and of the pulses obtained therefrom are determined or calculated, and in that the lower limit of the time window is set by the value of the maximum time lead before and the upper limit by the value of the maximum time lag after the expected instant of a further pulse.

3. Method according to Claim 1 or 2, characterized in that the relationship between the time spacings of the pulses and the lower limit or the upper limit of the time window is determined or calculated and stored in a table, and in that the stored values of the lower limit and of the upper limit, in the event of given time spacings of the pulses, are taken from the table and used in fixing the time window.

4. Method according to one of Claims 1 to 3, characterized in that in the event of the non-arrival of the pulse, the substitute pulse is used in the time window after the last pulse at the spacing of the last previous pulse.

5. Method according to one of Claims 1 to 3, characterized in that, in the event of the non-arrival of the pulse, the time sequence of previous pulses is evaluated and extrapolated, and in that the substitute pulse is used in the time window after the last pulse at the spacing of the extrapolated value.

6. Method according to Claim 4 or 5, characterized in that the substitute pulse is used in the time window of the upper limit of the time window, in that a measuring device registering the time spacings of successive pulses is preset by the time which has elapsed until the instant of the upper limit.

7. Circuit for the contactless speed measurement of vehicles, light being transmitted onto the surface of a road surface by means of optics, and the reflections being able to be evaluated with respect to an optical grid as continuously occurring time markings, from which pulses are obtained and their time spacings are measured, a time measuring device (10), preferably designed as a counter, being provided to measure the time spacings of the pulses, characterized in that the pulses are fed to a time-window-controlled gate circuit (12), in that the gate circuit (12) is connected to a pulse generator (14) which, in the event of the non-arrival of a pulse, generates a substitute pulse, in that comparison circuits (16, 18) are provided, which compare fixed lower limits and upper limits for the time window with the current time, the inputs for the lower and upper limits of the comparison circuits (16, 18) being connected to outputs of stores (20, 22) in which values of lower and upper limits are stored in tabular form, and in that the stores (20, 22) can be addressed by the time measuring device (10) .

8. Circuit according to Claim 7, characterized in that the gate circuit (12) can be opened and closed by the comparison circuits (16, 18).

9. Circuit according to Claim 7 or 8, characterized in that the pulse generator (14) is connected to a set input of the time measuring device (10), and in that the substitute pulse is used at the instant of the upper limit of the time window, in that the measuring device (10) is preset by the time which has elapsed until the instant of the upper limit.

## Revendications

1. Procédé de mesure sans contact de la vitesse de véhicules, selon lequel, à l'aide d'une optique on émet de la lumière vers la surface d'un revêtement de chaussée et on exploite les réflexions par rapport à une grille optique sous la forme de repères de temps se produisant en continu, pour donner des impulsions dont on mesure les intervalles de temps, procédé caractérisé en ce qu'à l'intervalle d'impulsions successives, après chaque fois la dernière impulsion, on forme une fenêtre de temps à l'intérieur de laquelle on surveille l'arrivée d'une autre impulsion et au cas où l'impulsion n'arrive pas, elle est remplacée par une impulsion de remplacement dans la fenêtre de temps, et, en fonction de la vitesse du véhicule, on décale la limite inférieure et la limite supérieure de la fenêtre de temps.

2. Procédé selon la revendication 1, caractérisé en ce qu'on définit ou on calcule les valeurs d'un décalage de temps maximum des repères de temps et des impulsions qui en découlent, et en ce que l'on avance la limite inférieure de la fenêtre de temps de la valeur de l'avance de temps maximale, tandis qu'on retarde la limite supérieure de la valeur du retard de temps maximum, après l'instant prévisible d'une autre impulsion.

3. Procédé selon la revendication 1 ou 2, caractérisé en ce qu'on détermine ou calcule la relation entre les intervalles de temps des impulsions et la limite inférieure ou la limite supérieure de la fenêtre de temps, et on les enregistre dans un tableau, les valeurs enregistrées des limites inférieures et supérieures étant extraites du tableau à des intervalles de temps donnés des impulsions ,et servent à fixer la fenêtre de temps.

4. Procédé selon l'une des revendications 1 à 3, caractérisé en ce que, lorsque l'impulsion n'arrive pas, l'impulsion de remplacement est mise en place à la distance de la dernière impulsion précédente après la dernière impulsion dans la fenêtre de temps.

5. Procédé selon l'une des revendications 1 à 3, caractérisé en ce que, lorsque l'impulsion n'arrive pas, on exploite la suite chronologique des impulsions précédentes et on extrapole et en ce qu'on place l'impulsion de remplacement en aval de la dernière impulsion dans la fenêtre de temps, à la distance correspondant à la valeur extrapolée.

6. Procédé selon la revendication 4 ou 5, caractérisé en ce qu'on place l'impulsion de remplacement dans la fenêtre de temps à la limite supérieure de la fenêtre, en pré-réglant une installation de mesure détectant les intervalles de temps d'impulsions successives, du temps écoulé jusqu'à l'instant de la limite supérieure.

7. Circuit de mesure sans contact de la vitesse d'un véhicule, une optique envoyant de la lumière à la surface d'un revêtement de chaussée et les réflexions étant exploitées comme des repères de temps se produisant en continu, par rapport à une grille optique, pour donner des impulsions dont on mesure les intervalles de temps, et, pour mesurer ces intervalles de temps des impulsions l'installation comprend une installation de mesure de temps (10), de préférence réalisée comme un compteur, caractérisé en ce que les impulsions sont appliquées à une porte (12) à commande de fenêtre de temps, et la porte (12) est reliée à un générateur d'impulsions (14) qui, lorsqu'une impulsion n'arrive pas, génère une impulsion de remplacement, des circuits de comparaison (16, 18) étant prévus pour comparer la limite inférieure ou la limite supérieure fixée de la fenêtre de temps, à l'instant réel, les entrées des limites inférieure et supérieure des circuits de temps (16, 18) étant reliées aux sorties des mémoires (20, 22) contenant, sous forme de tableau, les limites inférieure et supérieure, et en ce que les mémoires (20, 22) peuvent être adressées par l'installation de mesure de temps (10).

8. Circuit selon la revendication 7, caractérisé en ce que la porte (12) est ouverte et fermée par les circuits de comparaison (16, 18).

9. Circuit selon la revendication 7 ou 8, caractérisé en ce que le générateur d'impulsions (14) est relié à une entrée de mise à l'état de l'installation de mesure de temps (10), et en ce que l'impulsion de remplacement est utilisée à l'instant de la limite supérieure de la fenêtre de temps, en pré-réglant l'installation de mesure (10) du temps écoulé jusqu'à l'instant de la limite supérieure.
